# EUROPEAN PATENT SPECIFICATION

(11) **EP 4 134 009 B1**
(45) Date of publication and mention of the grant of the patent: **27.11.2024**
(21) Application number: 22185963.0
(22) Date of filing: 20.07.2022
(51) Int. Cl.: H10N 35/85, G01T 1/24

(54) **X-RAY AND PHOTODETECTION USING PHOTOINDUCED MAGNETOELECTRIC EFFECT**
RÖNTGEN- UND FOTODETEKTION MIT FOTOINDUZIERTEM MAGNETOELEKTRISCHEM EFFEKT
DÉTECTION DE RAYONS X ET PHOTODÉTECTION UTILISANT UN EFFET MAGNÉTOÉLECTRIQUE PHOTO-INDUIT

(30) Priority: 23.07.2021 US 202163225102 P
(43) Date of publication of application: 15.02.2023
(73) Proprietor: Lakehead University, Thunder Bay, ON P7B 5E1 (CA)
(72) Inventor: Albert, Mitchell, Thunder Bay, P7C 5Y4 (CA); Shepelytskyi, Yurli, Thunder Bay, P7B1L1 (CA); Hane, Francis, Thunder Bay, P7C 5E1 (CA); Zavislyak, Igor, Thunder Bay, P7C 5E1 (CA)
(74) Representative: Franke, Dirk

(56) References cited:
- JIA QI: "Enhanced Photocurrent in BiFeO 3 Materials by Coupling Temperature and Thermo-Phototronic Effects for Self-Powered Ultraviolet Photodetector System", APPLIED MATERIALS & INTERFACES, vol. 10, no. 16, 25 April 2018 (2018-04-25), US, pages 13712 - 13719, XP093162985, ISSN: 1944-8244, DOI: 10.1021/acsami.8b02543
- AFTABI ALI ET AL: "Magnetic anisotropies and its optical manipulation in epitaxial bismuth ferrite/ferromagnet heterostructure", JOURNAL OF MAGNETISM AND MAGNETIC MATERIALS, ELSEVIER, AMSTERDAM, NL, vol. 462, 30 April 2018 (2018-04-30), pages 160 - 166, XP085401845, ISSN: 0304-8853, DOI: 10.1016/J.JMMM.2018.04.053
- SHEPELYTSKYI YURII ET AL: "Photoinduced nonlinear magnetoelectric effect detection in Zn2Y hexaferrite", APPLIED PHYSICS LETTERS, AMERICAN INSTITUTE OF PHYSICS, 2 HUNTINGTON QUADRANGLE, MELVILLE, NY 11747, vol. 119, no. 6, 9 August 2021 (2021-08-09), XP012258767, ISSN: 0003-6951, [retrieved on 20210809], DOI: 10.1063/5.0050808
- SAFA KASAP ET AL: "Amorphous and Polycrystalline Photoconductors for Direct Conversion Flat Panel X-Ray Image Sensors", SENSORS, vol. 11, no. 12, 9 May 2011 (2011-05-09), pages 5112 - 5157, XP055321407, DOI: 10.3390/s110505112
- POPOV MAKSYM ET AL: "Nonlinear magnetoelectric effects in Y-type hexaferrite microwave resonators", JOURNAL OF APPLIED PHYSICS, AMERICAN INSTITUTE OF PHYSICS, 2 HUNTINGTON QUADRANGLE, MELVILLE, NY 11747, vol. 128, no. 11, 21 September 2020 (2020-09-21), XP012250207, ISSN: 0021-8979, [retrieved on 20200921], DOI: 10.1063/5.0021593
- LI XIU ET AL: "Photostriction of Ferrites Under Visible Light", ACS APPLIED ELECTRONIC MATERIALS, vol. 3, no. 6, 22 June 2021 (2021-06-22), pages 2534 - 2542, XP093044763, ISSN: 2637-6113, DOI: 10.1021/acsaelm.1c00077

## Description

### PRIOR APPLICATION INFORMATION

The instant application claims the benefit of US Provisional Patent Application 63/225,102, filed July 23, 2021 and entitled "X-ray and photodetection using photoinduced magnetoelectric effect".

### BACKGROUND OF THE INVENTION

X-ray diagnostics and computed tomography (CT) are the most commonly used medical imaging modalities. Currently, there are two ways to detect X-rays for medical imaging purposes: either using direct solid-state detectors (1, 2) (semiconductors based) or using indirect detectors based on the scintillators (3). However, the radiation dose associated CT scans is extremally high and, therefore, increase of detector sensitivity and performance speed is required. X-ray detectors can be characterized by a dead-time - the time that needs to be spent for collection of the electric charge which is proportional to the intensity of the detected radiation. Modern detectors are operated with dead-time of 10⁻⁶-10⁻⁷s (corresponding to the processing frequency of MHz) (4).

AFTABI A. ET AL: "Magnetic anisotropies and its optical manipulation in epitaxial bismuth ferrite/ferromagnet heterostructure",JOURNAL OF MAGNETISM AND MAGNETIC MATERIALS, vol. 462 (2018-04-30) describes the magnetoelectric properties of a Fe2B/BiFeO3 heterostructure focusing on the ferromagnetic resonance properties.

KASAP S. ET AL: "Amorphous and Polycrystalline Photoconductors for Direct Conversion Flat Panel X-Ray Image Sensors", SENSORS, vol. 11, no. 12 (2011-05-09) describes a large area photodetector array to measure intensity of electromagnetic irradiation.

POPOV M. ET AL: "Nonlinear magnetoelectric effects in Y-type hexaferrite microwave resonators", JOURNAL OF APPLIED PHYSICS, vol. 128, no. 11 (2020-09-21) describes nonlinear magnetoelectric properties of hexaferrite systems.

LI XIU ET AL: "Photostriction of Ferrites Under Visible Light",ACS APPLIED ELECTRONIC MATERIALS, vol. 3, no. 6 (2021-06-22) describes the photostrictive effect of magnetoelectric ferrites.

Jia Qi: "Enhanced Photocurrent in BiFeO3 Materials by Coupling Temperature and Thermo-Phototronic Effects for Self-Powered Ultraviolet Photodetector System", Applied Materials & Interfaces, vol. 10, no. 16 (2018-04-25) describes an photodetector array made of BiFeO3 detection units.

### SUMMARY OF THE INVENTION

According to a first aspect of the invention, there is provided a method for determining intensity of electromagnetic radiation as specified in claim 1.

In some embodiments of the invention, the crystal is a hexaferrite crystal, as discussed herein.

According to another aspect of the invention, there is provided a detector as specified in claim 4.

Outside the scope of the invention of radiation detection, the described photoinduced nonlinear magnetoelectric effect can be utilized to create optically coupled ferromagnetic resonators with radiation source such as, but not limited to, light-emitting diode (LED) that emits ultraviolet, visible, or infrared light. These coupled resonators can then be used in various microwave signal processing devices including, but not limited to, filters, phase shifters, and delay lines. For example, by alternating the voltage applied to the LED, the spectral characteristics and phase characteristics of the resonators can be tuned. As will be understood by one of skill in the art, this will increase the dynamic range of the microwave devices incorporating these resonators and will increase the quality factor of the microwave devices. As will be understood by one of skill in the art, these LED-coupled ferromagnetic resonators could be used as adaptive microwave antennas as well.

Outside the scope of the invention, the combination of at least one suitable ferrimagnetic crystal, or suitable ferromagnetic crystal and/or a suitable ferro(ferri)magnetic-photostrictive material heterostructure with an LED provides a coupled resonator which can then be used in various microwave signal processing devices including, but not limited to, filters, phase shifters, and delay lines, as discussed herein.

As used herein, the expression "suitable ferrimagnetic crystal or suitable ferromagnetic crystal" refers to any ferri(ferro)magnetic crystals in which the photoinduced magnetoelectric effect can be observed. While not wishing to be bound or limited to a particular theory or hypothesis, the inventors believe that such a suitable ferri(ferro)magnetic crystal should possess at least one but preferably both of the following properties: (1) semiconductor behavior; and (2) while the crystal is absorbing electromagnetic radiation, the generated photocurrent should be distinguished from the dark current that naturally flows through the crystal. As will be appreciated by one of skill in the art, these two properties are necessary for the magnetic to demonstrate a photoinduced magnetoelectric effect.

In addition, as discussed above, the photoinduced magnetoelectric effect can be observed in ferro(ferri)magnetic-photostrictive material heterostructures. As will be understood by one of skill in the art, the photostrictive material will create mechanical stress due to irradiation that will be transmitted to the ferri(ferro)magnetic material in the heterostructure. This mechanical stress will alter the internal magnetic properties of the magnetic materials resulting in the resonance frequency shift, creating the photoinduced magnetoelectric effect in photostrictive-ferro(ferri)magnetic heterostructure.

### BRIEF DESCRIPTION OF THE DRAWINGS

Figure 1. Current-Voltage Curves of Zn₂Y hexaferrite in absence (black curve) and presence (red curve) of the ultraviolet light.
Figure 2. The ferromagnetic resonance frequency shift caused by photoinduced magnetoelectric effect. The original ferromagnetic resonance peak is shown in solid line. The frequency shift due to magnetoelectric effect is shown in dashed line. The shift of the ferromagnetic resonance peak due to photoinduced magnetoelectric effect is shown by dot-dashed line.
Figure 3. Frequency shift of the Zn₂Y hexaferrite at different bias in absence (black curve) and presence (red curve) of the ultraviolet light.
Figure 4. Schematic diagram of one embodiment of a hexaferrite radiation detector device. The proposed detector is placed in an external magnetic field B₀. In addition, gradients of an external magnetic field are applied along X and Y axis (Gₓ and G_{y} respectively).

### DESCRIPTION OF THE PREFERRED EMBODIMENTS

Unless defined otherwise, all technical and scientific terms used herein have the same meaning as commonly understood by one of ordinary skill in the art to which the invention belongs. Although any methods and materials similar or equivalent to those described herein can be used in the practice or testing of the present invention, the preferred methods and materials are now described.

Described herein is the use of a biased hexaferrite ferrimagnetic semiconductive crystal for detection of the radiation on GHz frequencies. Recently, the presence of current induced magnetoelectric effect has been demonstrated in hexaferrites (5-7). It was shown that the frequency of either ferromagnetic or multidomain resonance of the hexaferrite semiconductor crystal can be changed due to electric current flow. Furthermore, the value of current can be calculated based on the frequency shift measurement.

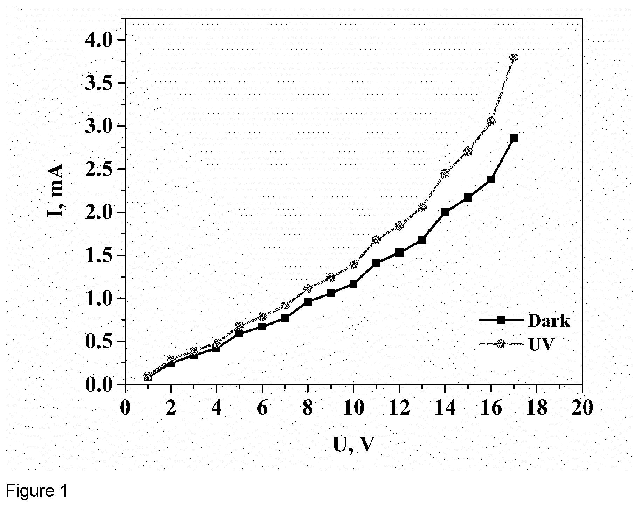

This principle can be used for radiation detection. We have successfully detected the internal photoelectric effect in Zn₂Y hexaferrite crystal (Figure 1).

As will be appreciated by one of skill in the art, while this has been demonstrated for Zn₂Y, any hexaferrite can be used until the hexaferrite crystal begins to exhibit semi-conductor behavior, as discussed herein.

Accordingly, the hexaferrite may be an M-type ferrite, a Z-type ferrite, a Y-type ferrite, a X-type ferrite or a U-type ferrite.

In some embodiments, the hexaferrite is a Y-type ferrite, having the general structure of (Ba/Sr)₂Me₂Fe₁₂O₁₂ where Me is a small 2⁺ ion such as for example cobalt, nickel or zinc and where Ba can be substituted by Sr.

Furthermore, any suitable ferrimagnetic crystal or suitable ferromagnetic crystal, for example, any ferri(ferro)magnetic crystals in which the photoinduced magnetoelectric effect can be observed, may be used within the invention, as discussed herein.

In addition, as discussed above, the photoinduced magnetoelectric effect can be observed in ferro(ferri)magnetic-photostrictive material heterostructures. As will be understood by one of skill in the art, the photostrictive material will create mechanical stress due to irradiation that will be transmitted to the ferri(ferro)magnetic material in the heterostructure. This mechanical stress will alter the internal magnetic properties of the magnetic materials resulting in the resonance frequency shift, creating the photoinduced magnetoelectric effect in photostrictive-ferro(ferri)magnetic heterostructure.

As will be appreciated by one of skill in the art, in some embodiments, the heterostructure comprises photostrictive material placed in mechanical contact with ferri(ferro)magnetic materials. The type of photostrictive material will depend on the type of radiation desired to be detected. For example, lead lanthanum zirconate titanate (PLZT) materials with a general structure Pb(₁₋ₓ)Laₓ(Zr_{y}Ti_{1-y})_{1-x/4}O₃ can be used as photostrictive material for UV light detection.

Since the photostrictive material will interact with the radiation initially, there are no restrictions on the type or composition of the magnetic materials used.

Accordingly, any ferro(ferri)magnetic material can be used in conjunction with photostrictive material to create a heterostructure. For example, the yttrium iron garnet (Y₃Fe₅O₁₂) can be used as a ferrimagnetic material. Alternatively, hexaferrites mentioned above can be also utilized for engineering of ferrimagnetic-photostrictive heterostructures.

In some embodiments, the ferrite garnets with a general formula of Me₃Fe₅O₁₂ (where Me is a metal cations) can be used in the discussed heterostructures.

As can be appreciated by one of skill in the art, any substituted materials could also be possible to use for the ferri(ferro)magnetic-photostrictive heterostructure.

While not wishing to be bound or limited to a particular theory or hypothesis, the inventors believe that such a suitable ferri(ferro)magnetic crystal or photostrictiveferro(ferri)magnetic heterostructure should possess at least one but preferably both of the following properties: (1) semiconductor behavior; and (2) while the crystal is absorbing electromagnetic radiation, the generated photocurrent should be distinguished from the dark current that naturally flows through the crystal. As will be appreciated by one of skill in the art, these two properties are necessary for the magnetic to demonstrate a photoinduced magnetoelectric effect.

According to a first aspect of the invention defined by the claims, there is provided a method for determining intensity of electromagnetic radiation.

In some embodiments of the invention, the suitable crystal is a hexaferrite crystal, as discussed herein.

According to another aspect of the invention, there is provided a detector as defined by the claims.

Outside the scope of the invention of radiation detection, the described photoinduced nonlinear magnetoelectric effect can be utilized to create optically coupled ferromagnetic resonators with radiation source such as, but not limited to, light-emitting diode (LED) that emits ultraviolet, visible, or infrared light. These coupled resonators can then be used in various microwave signal processing devices including, but not limited to, filters, phase shifters, and delay lines. For example, by alternating voltage applied to LED, the spectral characteristics and phase characteristics of the resonators can be tuned. As can be understood by one of skill in the art, this will increase the dynamic range of the described microwave devices and will increase the quality factor of the microwave devices. As will be understood by one skilled in the art, these LED-coupled ferromagnetic resonators could be used as adaptive microwave antennas as well.

Accordingly, in some embodiments outside the scope of the invention, there is provided use of at least one suitable ferrimagnetic crystal, or suitable ferromagnetic crystal and/or a suitable ferro(ferri)magnetic-photostrictive material heterostructure with a light-emitting diode (LED).

In some embodiments, the LED emits ultraviolet, visible, or infrared light.

As will be appreciated by one of skill in the art, the combination of at least one suitable ferrimagnetic crystal, or suitable ferromagnetic crystal and/or a suitable ferro(ferri)magnetic-photostrictive material heterostructure with an LED provides a coupled resonator which can then be used in various microwave signal processing devices including, but not limited to, filters, phase shifters, and delay lines, as discussed herein.

Accordingly, in some embodiments outside the scope of the invention, there is provided a coupled resonator comprising at least one suitable ferrimagnetic crystal, suitable ferromagnetic crystal and/or suitable ferro(ferri)magnetic-photostrictive material heterostructure and a light-emitting diode (LED).

In some embodiments, the LED emits ultraviolet, visible, or infrared light. Figure 1 shows the measured DC current-voltage characteristics (CVC) of the sample measured without (black curve), and with, UV irradiation (red curve). The dark CVC became nonlinear for the applied voltages higher than 13 V, indicating semiconductor behavior. Once irradiated with UV light, nonlinear behavior of CVC was detected at 11 V and the photocurrent increased non-linearity of the CVC. The detectable difference between the dark current and photocurrent indicates the possibility of utilizing Zn₂Y for radiation detection since this difference causes an additional change in the ferromagnetic resonance of the crystal.

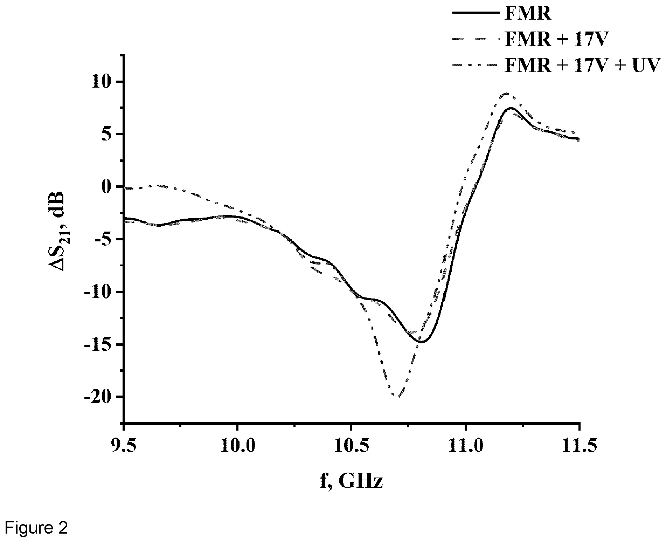

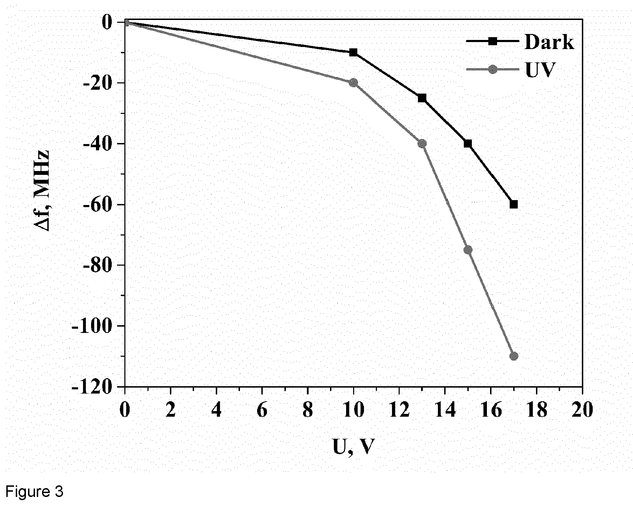

Following the detection of photoelectric effect in Zn₂Y crystal, we have successfully detected a photoinduced nonlinear magnetoelectric effect in the monocrystal of Zn₂Y (Figure 2). The ferromagnetic resonance of the hexaferrite crystal was observed at 10.81 GHz (Figure 2 black curve). Once 17V bias was applied, the resonance frequency shifted down to the 10.75 GHz (Figure 2 red curve). When the crystal was irradiated by ultraviolet light, an 83% larger shift in the ferromagnetic resonance frequency was observed (Figure 2 blue curve). The ferromagnetic resonance frequency under ultraviolet radiation was equal to 10.7 GHz. The dependence of the ferromagnetic resonance frequency shift on bias voltage is shown in Figure 3.

These results demonstrate how radiation can be detected by exploiting this photoinduced nonlinear magnetoelectric effect. Specifically, once the crystal is irradiated, the photocurrent induces change in resonance frequency (Figure 3) of the sample by affecting its internal magnetic field distribution. This resonance frequency change is proportional to the induced photocurrent and, therefore, the radiation intensity. By measuring the resonance frequency change caused by exposing a hexaferrite crystal to photoinduced nonlinear magnetoelectric effect it is possible to obtain the intensity of the incidental radiation.

This phenomenon can be extended for the detection of any type of electromagnetic radiation. If hexaferrite crystal is biased and irradiated by any electromagnetic waves, and/or experiences an internal photoelectric effect, the frequency of ferromagnetic resonance will be changed proportionally to the intensity of absorbed radiation. Therefore, by conducting frequency measurement of the ferromagnetic resonance similar to the approach demonstrated above, it is possible to measure the intensity of the incoming radiation.

As will be appreciated by one of skill in the art, using a matrix of hexaferrite resonators placed for example on copper transmission lines produces a radiation detector capable of detecting radiation locally.

In some embodiments, to make the resonance frequency of every resonator unique, a matrix or array of crystals can be placed in a 2D magnetic field gradient. In these embodiments, the reference signal can be generated by, for example, a sweep generator with a spectrum broad enough to cover all resonance frequencies of the crystals in the hexaferrite matrix. In these embodiments, the resonance frequency measurements are made using for example a microwave spectrometer. Since the resonance frequency of each crystal is unique, it is easy to quantify the intensity of electromagnetic radiation which was absorbed by every pixel on the matrix. As will be apparent to one of skill in the art, detectors built using this approach can be used for detection of any radiation for example but by no means limited to visible light, ultraviolet light, X-rays and the like. Thus, these detectors can be implemented in a variety of spectrometers and medical imaging modalities.

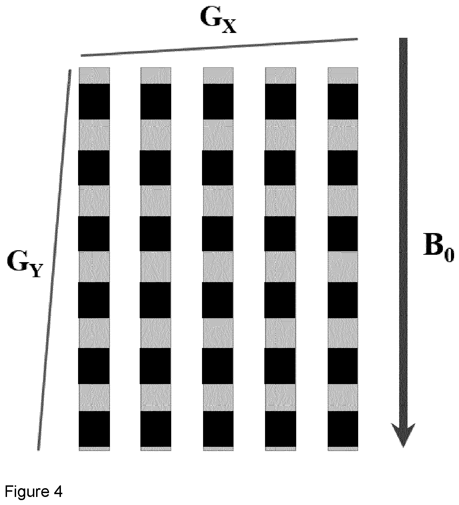

For example, to perform X-ray imaging using photoinduced non-linear magnetoelectric effect as described herein, an array of MxN hexaferrite resonators as described herein is arranged. As will be apparent to one of skill in the art, the matrix size can vary depending on the end application. For, example, a CT detector matrix will be larger than a digital mammography detector or a fluoroscopy detector. The shape of the detector may also vary depending on the potential application - for example, CT detectors would likely be curved but in other applications, the detector may be flat or substantially flat. As discussed above, the MxN hexaferrite matrix is placed in a gradient magnetic field in order to magnetize ferrimagnetic resonators and to create a specific resonance frequency for each respective one resonator. The array size will also vary depending on the application. For instance, for digital mammography, the array might be on the order of 25x25 cm² so as to be similar in size to previously developed direct digital detectors. An example of a suitable detector construction can be seen in Figure 4.

Specifically, as can be seen from Figure 4, it is placed in the external magnetic field B0, and the gradients of the external magnetic field are created along X- and Y-axes (Gx and Gy respectively). In use, similar to prior art devices, the patient would be placed between the radiation source and the detector. The radiation source and the detector could either rotate around the patient to obtain images at different angles (for CT or fluoroscopy imaging purposes) or remain stationary (for conventional 2D X-ray imaging). The radiation attenuated by the patient will be detected by the crystalline array, as discussed above.

Unlike radiation detectors that rely on photocurrent measurement and quantification, an array of hexaferrite resonators does not require any additional electronic circuits designed for charge collection and/or current measurement. Therefore, manufacturing of the hexaferrite radiation detector described herein will avoid the difficulties associated with solid-state radiation detectors. In addition, unlike conventional radiation detectors that frequently utilize amorphous and polycrystalline materials, the hexaferrite radiation detector utilizes hexaferrite monocrystals, which significantly improves the charge carrier mobilities. Finally, the hexaferrite radiation detector has a working frequency of 10-100 GHz which is up to 4 orders of magnitude higher than currently available radiation detectors. Utilization of such operating frequencies produces increases in signal detection speed and will result in significant reduction of radiation dose required for a single scan. In addition, faster performance of the hexaferrite radiation detector will allow for a substantial increase in the resulting image quality.

The primary advantage of this radiation detection device is the high operating frequencies, as discussed above, which result in a significantly shorter dead time for the detector. For example, the known hexaferrite crystal Zn₂Y experiences ferromagnetic resonance around 12 GHz. Barium hexaferrite (BaFe₁₂O₁₉) has a resonance frequency - 50 GHz. These operating frequencies are several orders of magnitude higher compared to the frequencies commonly used with for example X-ray detection. Therefore, hexaferrite detectors based on photoinduced magnetoelectric effect potentially will have significantly shorter dead-time which means that a lower radiation dose is needed to obtain the same signal-to-noise ratio of an X-ray image.

This will also significantly improve safety of modern CT and fluoroscopy scans.

### REFERENCES

1. Kasap, S. et al. Amorphous and Polycrystalline Photoconductors for Direct Conversion Flat Panel X-Ray Image Sensors. Sensors 11, 5112-5157 (2011). doi: 10.3390/s110505112.
2. Karasyuk, P. et al. Investigation of photoconductivity and electric field distribution in CZT detectors by time-of-flight (TOF) and charge extraction by linearly increasing voltage (CELIV). J. Mater. Sci. Mater. Electron. 29, 13941-13951 (2018). doi: 10.1007/s10854-018-9527-9
3. Martin, T. et al. LSO-based single crystal film scintillator for synchrotron-based hard X-ray micro-imaging. IEEE Trans. Nucl. Sci. 56, 1412-1418 (2009). doi: 10.1109/TNS.2009.2015878.
4. Krzyzanowska, A., Otfinowski, P. & Grybos, P. Simulations of High Count Rate Performance of Hybrid Pixel Detectors with Algorithms Dealing with Charge Sharing. in 2018 International Conference on Signals and Electronic Systems, ICSES 2018 - Proceedings 23-26 (Institute of Electrical and Electronics Engineers Inc., 2018). doi: 10.1109/ICSES.2018.8507325.
5. Zavislyak, I. V., Popov, M. A. & Srinivasan, G. Current-induced nonlinear magnetoelectric effects in strontium hexaferrite. Phys. Rev. B 94, 224419 (2016) doi:10.1103/PhysRevB.94.224419.
6. Popov, M. A., et. al. Nonlinear magnetoelectric effects in Y-type hexaferrite microwave resonators. J. Appl. Phys. 128, 113905 (2020) doi: 10.1063/5.0021593
7. Liu, Y., et. al. Nonlinear magnetoelectric effects in AI-substituted strontium hexaferrite. Sci. Rep. 11, 8733. doi: 10.1038/s41598-021-88203-w

## Claims

1. A method for determining intensity of electromagnetic radiation, comprising:
providing a plurality of ferrimagnetic and/or ferromagnetic crystals suitable for producing a photoinduced magnetoelectric effect arranged in an array, each respective ferrimagnetic or ferromagnetic crystal having a different control resonance frequency;
exposing the ferrimagnetic and/or ferromagnetic crystals
to electromagnetic radiation of unknown intensity or variable intensity such that the ferrimagnetic and/or ferromagnetic crystals undergo an internal photoelectric effect,
measuring an irradiated resonance frequency of the irradiated ferrimagnetic and/or ferromagnetic crystals; and
determining the intensity of the electromagnetic radiation irradiating the ferrimagnetic and/or ferromagnetic crystals from the respective control resonance frequency and the respective irradiated resonance frequency.

2. The method according to claim 1 wherein each ferrimagnetic crystal is a hexaferrite crystal.

3. The method according to claim 1 wherein the intensity of the electromagnetic radiation is proportional to the resonance frequency change.

4. A detector comprising:
a plurality of ferrimagnetic and/or ferromagnetic crystals suitable for producing a photoinduced magnetoelectric effect arranged in an array,
said array within a two-dimensional magnetic field gradient (G_{X}, G_{Y}) such that each respective one ferrimagnetic and/or ferromagnetic crystal has a unique resonance frequency;
a detection unit for measuring the intensity of an electromagnetic irradiation of various or unknown intensity; and
a microwave spectrometer for measuring resonance frequencies.

5. The detector according to claim 4 wherein each ferrimagnetic crystal is a hexaferrite crystal.

6. The detector according to claim 4 wherein the intensity of the electromagnetic radiation is proportional to the resonance frequency change.

## Patentansprüche

1. Verfahren zur Bestimmung der Intensität von elektromagnetischer Strahlung, umfassend:
Bereitstellung einer Vielzahl von ferrimagnetischen und/oder ferromagnetischen Kristallen, die dazu geeignet sind, einen photoinduzierten magnetoelektrischen Effekt zu erzeugen, angeordnet in einem Array, wobei jeder entsprechende ferrimagnetische oder ferromagnetische Kristall eine unterschiedliche Steuerresonanzfrequenz aufweist;
Aussetzung der ferrimagnetischen und/oder ferromagnetischen Kristalle gegenüber elektromagnetischer Strahlung unbekannter oder variabler Intensität, sodass die ferrimagnetischen und/oder ferromagnetischen Kristalle einen internen photoelektrischen Effekt erfahren;
Messung einer bestrahlten Resonanzfrequenz der bestrahlten ferrimagnetischen und/oder ferromagnetischen Kristalle; und
Bestimmung der Intensität der elektromagnetischen Strahlung, die die ferrimagnetischen und/oder ferromagnetischen Kristalle bestrahlt, basierend auf der jeweiligen Steuerresonanzfrequenz und der jeweiligen bestrahlten Resonanzfrequenz.

2. Verfahren gemäß Anspruch 1, wobei jeder ferrimagnetische Kristall ein Hexaferrit-Kristall ist.

3. Verfahren gemäß Anspruch 1, wobei die Intensität der elektromagnetischen Strahlung proportional zur Änderung der Resonanzfrequenz ist.

4. Detektor, umfassend:
eine Vielzahl von ferrimagnetischen und/oder ferromagnetischen Kristallen, die zur Erzeugung eines photoinduzierten magnetoelektrischen Effekts geeignet sind, angeordnet in einem Array, wobei sich das Array in einem zweidimensionalen Magnetfeldgradienten (G_{X}, G_{Y}) befindet, sodass jeder entsprechende ferrimagnetische und/oder ferromagnetische Kristall eine einzigartige Resonanzfrequenz hat;
einen Detektor zur Messung der Intensität einer elektromagnetischen Bestrahlung unterschiedlicher oder unbekannter Intensität; und
ein Mikrowellen-Spektrometer zur Messung von Resonanzfrequenzen.

5. Detektor gemäß Anspruch 4, wobei jeder ferrimagnetische Kristall ein Hexaferrit-Kristall ist.

6. Detektor gemäß Anspruch 4, wobei die Intensität der elektromagnetischen Strahlung proportional zur Änderung der Resonanzfrequenz ist.

## Revendications

1. Procédé de détermination de l'intensité d'une radiation électromagnétique, comprenant :
la mise à disposition d'une pluralité de cristaux ferrimagnétiques et/ou ferromagnétiques, adaptés à la génération d'un effet magnétoélectrique photoinduit, disposés dans un réseau, chaque cristal ferrimagnétique ou ferromagnétique respectif ayant une fréquence de résonance de contrôle différente ;
l'exposition des cristaux ferrimagnétiques et/ou ferromagnétiques à une radiation électromagnétique d'intensité inconnue ou variable, de sorte que les cristaux ferrimagnétiques et/ou ferromagnétiques subissent un effet photoélectrique interne ;
la mesure d'une fréquence de résonance irradiée des cristaux ferrimagnétiques et/ou ferromagnétiques irradiés ; et
la détermination de l'intensité de la radiation électromagnétique irradiant les cristaux ferrimagnétiques et/ou ferromagnétiques, basée sur la fréquence de résonance de contrôle respective et la fréquence de résonance irradiée respective.

2. Procédé selon la revendication 1, dans lequel chaque cristal ferrimagnétique est un cristal d'hexaferrite.

3. Procédé selon la revendication 1, dans lequel l'intensité de la radiation électromagnétique est proportionnelle à la variation de la fréquence de résonance.

4. Détecteur, comprenant :
une pluralité de cristaux ferrimagnétiques et/ou ferromagnétiques, adaptés à la génération d'un effet magnétoélectrique photoinduit, disposés dans un réseau, ledit réseau étant situé dans un gradient de champ magnétique bidimensionnel (G_{X}, G_{Y}), de sorte que chaque cristal ferrimagnétique et/ou ferromagnétique respectif ait une fréquence de résonance unique ;
un détecteur pour mesurer l'intensité d'une irradiation électromagnétique d'intensité différente ou inconnue ; et
un spectromètre micro-onde pour mesurer les fréquences de résonance.

5. Détecteur selon la revendication 4, dans lequel chaque cristal ferrimagnétique est un cristal d'hexaferrite.

6. Détecteur selon la revendication 4, dans lequel l'intensité de la radiation électromagnétique est proportionnelle à la variation de la fréquence de résonance.
